# EUROPÄISCHE PATENTSCHRIFT

(11) **EP 2 467 670 B1**
(45) Veröffentlichungstag und Bekanntmachung des Hinweises auf die Patenterteilung: **23.03.2016**
(21) Anmeldenummer: 10742773.4
(22) Anmeldetag: 12.08.2010
(51) Int. Cl.: H03K 17/95, G01B 7/02, H01F 5/02, H01F 27/32

(54) **INDUKTIVER ABSTANDSSENSOR**
INDUCTIVE DISTANCE SENSOR
CAPTEUR DE DISTANCE INDUCTIF

(30) Priorität: 18.08.2009 DE 102009037808
(43) Veröffentlichungstag der Anmeldung: 27.06.2012
(73) Patentinhaber: Diehl Aerospace GmbH, 88662 Überlingen (DE)
(72) Erfinder: TRUNK, Lothar, 63879 Weibersbrunn (DE); HEITEFUSS, Norbert, 60433 Frankfurt (DE); HOUP, Alan Lowell, 60598 Frankfurt a. Main (DE)
(74) Vertreter: Diehl Patentabteilung
(86) Internationale Anmeldenummer: PCT/EP2010/004943
(87) Internationale Veröffentlichungsnummer: WO 2011/020580

(56) Entgegenhaltungen:
- WO-A1-2007/131373

## Beschreibung

Die Erfindung betrifft einen induktiven Abstandssensor gemäß dem Oberbegriff des Hauptanspruches.

Ein Abstandssensor ist beispielsweise aus der DE 1 03 28 122 A1 bekannt.

Die kernbestückte Spule eines derartigen induktiven Abstandssensors wird von einer Schwingschaltung mit Mittelfrequenz gespeist, die in ferromagnetischer Umgebung Wirbelstromverluste hervorruft. Das führt zur Amplituden- und Phasen beeinflussung der Speisefrequenz, wenn sich die ferromagnetische Masse infolge Annäherung oder Entfernung eines ferromagnetischen Gegenstandes, wie etwa eines lokal eisenbeschlagenen Türflügels, ändert. Damit lässt solch ein Abstandssensor sich nicht nur als Endschalter einsetzen, sondern auch als Abstandsmesseinrichtung hoher Auflösung. Allerdings ist für solchen Einsatz als Meßsystem ein zeitaufwändiger und fehleranfälliger induktiver Abgleich erforderlich.

Um solchen potentiell fehlerbehafteten Abgleich und darauf zurückzuführende Messfehler einzuschränken, ist bei der DE 1 03 28 122 A1 im Wesentlichen vorgesehen, den gegenüber dem Kern Übermaß aufweisenden Innenwanddurchmesser des Wicklungsträgers an verschiedenen Umfangspositionen seiner Innenmantelfläche federelastisch zu verjüngen, so dass der dazwischen eingeführte Kern unabhängig von seinem Zylinderdurchmesser stets im Wicklungsträger zentriert ist.

Regelmäßig ist aber ein Feinabgleich über eine lineare oder schraubenförmige Axialverlagerung und abschließende Festlegung des Kernes im Wicklungsträger unumgänglich. Dabei ist es für die Serienfertigung von Nachteil, dass bei einer in einem ferromagnetischen Topf angeordneten Spule trotz gleicher Spulenkenndaten der Abgleich nur bei von Spule zu Spule unterschiedlichen Axialstellungen des Kernes in seinem Wicklungsträger erreicht wird.

Ein Abstandssensor nach dem Oberbegriff des Anspruchs 1 ist beispielsweise aus der WO 2007/131373 bekannt.

In Erkenntnis obiger Gegebenheiten liegt vorliegender Erfindung die technische Problemstellung zugrunde, bei einem gattungsgemäßen induktiven Abstandssensor im Interesse sowohl höherer Messgenauigkeit wie auch höherer Fertigungsrate den Abgleichaufwand zu verringern und eine vereinfachte Montage zu eröffnen.

Diese Aufgabe ist erfindungsgemäß nach der Merkmalskombination des Hauptanspruches gelöst. Danach weisen zwei an den Stirnenden des rohrförmigen Wicklungsträgers befindliche ringscheibenförmige Flansche geringfügig unterschiedliche Außendurchmesser auf. Der Außendurchmesser der auf den Wicklungsträger aufzubringenden Spule ist dadurch maximal auf den Außendurchmesser des kleineren Flansches beschränkt. Dem entspricht der Innendurchmesser eines vom kleineren Flansch her über die Wicklung gestülpten Topfes aus ferromagnetischem Material, dessen offener Stirnrand dann gegen die der Spule zugewandte Innenfläche des größeren Flansches anliegt. Dadurch ist der geometrisch genau definierte Ringraum zwischen den Flanschen sowie zwischen Wicklungsträger und Topf-Wandung mit der Spule gefüllt. Überraschenderweise hat sich gezeigt, dass bei dieser Auslegung nach dem Raumfüllfaktor der Spule die axiale Lage des Kernes im Wicklungsträger praktisch nicht mehr kritisch ist. Der braucht also nun nicht mehr schraubbolzenähnlich mit einem Außengewinde mehr der weniger tief in den Wicklungsträger des Spulenkörpers eingedreht zu werden; es genügt nach der Erfindung, einen Kern mit glatter Außenmantelfläche im Wicklungsträger zu haltern. Das geschieht an Einfachsten, wenn der Kern mit einem Stirnende im Zentrum des Topf-Bodens montiert oder angeformt ist und somit im Zuge des Überstülpens des Topfes über die Spule in das Innere des rohrförmigen Wicklungsträgers eingeschoben wird.

Erfindungsgemäß sind hinter dem rückwärtigen Flansch achsparallele Abstandspfeiler vorgesehen, so dass der Boden des Topfes gegen den rückwärtigen Flansch auf Distanz gehalten ist.

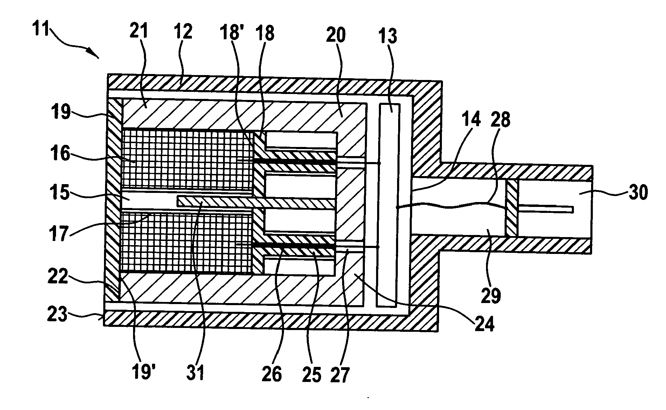

Zusätzliche Weiterbildungen und Alternativen zur erfindungsgemäßen Lösung ergeben sich aus den weiteren Ansprüchen und, auch hinsichtlich deren Vorteilen, aus nachstehender Beschreibung eines in der Zeichnung nicht ganz maßstabsgerecht auf das Funktionswesentliche abstrahiert skizzierten bevorzugten Ausführungsbeispiels zur Erfindung. Die einzige Figur der Zeichnung zeigt im Axiallängsschnitt den Aufbau eines erfindungsgemäß ausgelegten induktiven Wirbelstrom-Abstandssensors.

Der skizzierte induktiv arbeitende Abstandssensor 11 weist in einem hohlzylindrischen Umgehäuse 12 eine etwa kreisscheibenförmige Leiterplatte 13 mit einer elektronischen Schwingschaltung 14 auf, einschließlich gegebenenfalls Stromversorgung und einer Messauswerteschaltung. Die Schwingschaltung 14 speist eine axial davor auf einen Spulenkörper 15 aus Kunststoff aufgebrachte Spule 16 mit Mittelfrequenz (im ein- bis zweistelligen Kilohertzbereich). Die Spule 16 ist auf einen rohrförmigen Wicklungsträger 17 gewickelt, dessen beiden Stirnenden mit ringscheibenförmigen Flanschen 18, 19 ausgestattet sind. Von denen weist der vordere (19) einen Außendurchmesser vom Innendurchmesser des Umgehäuses 12 und der rückwärtige (18) einen dagegen etwas geringeren Außendurchmesser auf. So ergibt sich ein konstruktiv vorgegebenes maximales Wicklungsvolumen, das axial durch die Länge des Wicklungsträgers 17 zwischen seinen Flanschen 18-19 definiert ist, und radial durch den Außendurchmesser des rückwärtigen, kleineren Flansches 18. Die Spule 16 erstreckt sich immer genau zwischen den aufeinander zu weisenden Innenflächen 18'-19' der Flansche 18, 19, und vom Außendurchmesser des Wicklungsträgers 17 bis maximal zum Außendurchmesser des rückwärtigen Flansches 18.

Der so mit der Spule 16 bestückte Spulenkörper 15 wird in einem Topf 20 aus ferromagnetischem Material aufgenommen. Dessen hohlzylindrische Wand 21 weist einen Außendurchmesser vom Innendurchmesser des Umgehäuses 12 und einen Innendurchmesser auf, der allenfalls geringfügig größer ist als der Außendurchmesser des kleineren Flansches 18. So kann der Topf 20 axial von rückwärts her über den mit der Spule 16 bestückten Spulenkörper 15 gestülpt werden, bis der Wandungs-Stirnrand 22 axial gegen den äußeren Ringbereich der vorderen, größeren Flansch-Innenfläche 19' zur Anlage gelangt. Da der Außendurchmesser des vorderen Flansches 19 gleich demjenigen der Topf-Wand 21 misst, kann der Spulenkörper 15 samt Topf 20 vorne, messseitig, bündig mit der Stirn 23 des Abstandssensor-Umgehäuses 12 abschließen.

Im Interesse einer größeren Masse, nämlich infolge einer gegenüber dem Wicklungsträger 17 axial längeren Wand 21 des Topfes 20, liegt dessen Boden 24 nicht direkt hinter dem rückwärtigen Flansch 18 gegen diesen an; sondern er ist hiergegen mittels Pfeilern 25 auf Distanz gehalten, die rückwärtig am kleineren Flansch 18 parallel zur Längsachse des Umgehäuses 12 vorgesehen (angeformt oder angebracht) sind. Die Pfeiler 25 sind mit Längskanälen 26 ausgestattet, durch die - und korrespondierende Löcher 27 im Topf-Boden 24 - hindurch Drahtenden oder Anschlussdrähte der Spule 16 an die Leiterplatte 13 geführt sind. Diese ist mittels einer Leitungsführung 28 durch einen gegenüber dem Umgehäuse 12 verjüngten Hohlstutzen 29 hindurch mit einem rückwärtig zugänglichen Anschlußstecker 30 für den Betrieb der Schaltungen auf der Leiterplatte 13 verbunden.

Infolge des axial fest und radial maximal vorgegebenen Volumens der Spule 16 zwischen den Flanschen 18-19 innerhalb des Topfes 20 ist die genaue axiale Lage eines ferromagnetischen Kernes 31 im Wicklungsträger 17 unkritisch geworden, ein Positionierungsabgleich hinsichtlich des Abstandes des Kernes 31 von der Ebene der messseitigen Stirn 23 des Umgehäuses 12, und damit ein induktives Kalibrieren des Abstandssensors 11, ist nun regelmäßig nicht mehr erforderlich. Deshalb ist es möglich geworden, den Kern 31 vor dem Zentrum des Topf-Bodens 24 zu platzieren (anzuformen oder anzubringen), um im Zuge des axialen Überstülpens des Topfes 20 über den bestückten Spulenkörper 15 zugleich den Kern 31 koaxial in den Wicklungsträger 17 einzuführen. Der Kern 31 braucht deshalb nicht mehr darin gesondert kraft- oder formschlüssig festgelegt zu werden.

Ein induktiver Abgleich der kernbestückten Spule 16 eines Wirbelstrom-Abstandssensors 11 lässt sich so vermeiden, wenn die Spule 16 erfindungsgemäß einen konstruktiv vorgegebenen Ringraum zwischen dem Wicklungsträger 17 des Kunststoff-Spulenkörpers 15 und dessen Flanschen 18-19 sowie der Wand 21 eines Topfes 20 aus ferromagnetischem Material ausfüllt, der über den rückwärtigen, kleineren Flansch 18 gestülpt ist und stirnseitig 21 gegen einen Ringbereich des vorderen, größeren Flansches 19 vom Durchmesser des Topfes 20 anliegt. Der koaxial in den Wicklungsträger 17 eingreifende ferromagnetische Spulen-Kern 31 kann deshalb im Topf 20 auf dessem Boden 24 angeordnet sein und so in einem Zuge mit dem Topf 20 montiert werden.

### Bezugszeichenliste

- 11: Abstandssensor
- 12: Umgehäuse (von 11)
- 13: Leiterplatte (in 12 hinter 15-20)
- 14: Schwingschaltung (auf 13)
- 15: Spulenkörper (in 20-12)
- 16: Spule (auf 17)
- 17: Wicklungsträger (von 15)
- 18: kl. Flansch (von 17)
- 19: gr. Flansch (von 17)
- 20: Topf (in 12 über 18 hinter 19)
- 21: Wand (von 20)
- 22: Stirnrand (von 21 hinter 19)
- 23: Stirn (von 12)
- 24: Boden (von 20, hinter 18)
- 25: Pfeiler (hinter 18)
- 26: Längskanäle (durch 25)
- 27: Löcher (in 24, hinter 26)
- 28: Leitungsführung (von 13 durch 29 nach 30)
- 29: Hohlstutzen (hinter 12)
- 30: Anschlussstecker (für 11 am rückwärtigen Ende von 29)
- 31: Kern (in 17)

## Patentansprüche

1. Induktiver Abstandssensor (11) mit einem Spulenkörper (15), dessen rohrförmiger Wicklungsträger (17) mit einem ferromagnetischen Kern (31) und, zwischen Flanschen (18-19) an seinen Stirnenden, mit einer Spule (16) bestückt ist, wobei zwei kreisringförmige Flansche (18, 19) unterschiedlicher Außendurchmesser vorgesehen sind und der bestückte Spulenkörper (15) in einem ferromagnetischen Topf (20) angeordnet ist, dessen Innendurchmesser dem Außendurchmesser des rückwärtigen, kleineren Flansches (18) entspricht, **dadurch gekennzeichnet dass**, hinter dem rückwärtigen Flansch (18) achsparallele Abstandspfeiler vorgesehen sind, und dass der Boden (24) des Topfes (20) nicht direkt hinter dem rückwärtigen Flansch (18) gegen diesen anliegt sondern hiergegen mittels den Abstandsfeilern (25) auf Distanz gehalten ist.

2. Abstandssensor nach dem vorangehenden Anspruch, **dadurch gekennzeichnet, dass** der Außendurchmesser des Topfes (20) dem Außendurchmesser des vorderen, größeren Flansches (19) und dem Innendurchmesser eines Umgehäuses (12) entspricht.

3. Abstandssensor nach einem der vorangehenden Ansprüche, **dadurch gekennzeichnet, dass** der Ringraum zwischen dem Wicklungsträger (17) und der Topf-Wandung (21) mit der Spule (16) gefüllt ist.

4. Abstandssensor nach einem der vorangehenden Ansprüche, **dadurch gekennzeichnet, dass** der Topf (20) auf seinem Boden (24) mit einem in den Wicklungsträger (17) koaxial eingreifenden Kern (31) ausgestattet ist.

5. Abstandsensor nach dem vorangehenden Anspruch, **dadurch gekennzeichnet, dass** der Topf (20) mit seinem Boden (24) gegen die Pfeiler (25) und mit seinem Stirnrand (22) gegen einen Ringbereich des vorderen Flansches (19) anliegt.

6. Abstandssensor nach Anspruch 2, umfassend des Weiteren ein hohlzylindrisches Umgehäuse (12), in welchem der Topf (20) angeordnet ist, wobei eine kreisscheibenförmige Schaltungs-Leiterplatte (13) zwischen dem Topf-Boden (24) und Boden des Umgehäuses (12) angeordnet ist.

7. Abstandssensor nach dem vorangehenden Anspruch, **dadurch gekennzeichnet, dass** die Spule (16) durch Längskanäle (26) in den Pfeilern (25) und durch Löcher (27) im Topf-Boden (24) hindurch an die Leiterplatte (13) angeschlossen ist.

8. Abstandssensor nach Anspruch 2, **dadurch gekennzeichnet, dass** der Spulenkörper (15) samt Topf (20) messseitig bündig mit der Stirn (23) des Abstandssensor-Umgehäuses (12) abschließt.

## Claims

1. Inductive distance sensor (11) having a coil former (15) whose tubular winding support (17) is fitted with a ferromagnetic core (31) and, between flanges (18-19) on its end faces, with a coil (16), wherein two annular flanges (18, 19) with different external diameters are provided, and the populated coil former (15) is arranged in a ferromagnetic pot (20) whose internal diameter corresponds to the external diameter of the rearward, smaller flange (18) **characterized in that** spacing pillars which are parallel to the axis are provided behind the rearward flange (18), and **in that** the base (24) of the pot (20) does not rest directly behind the rearward flange (18) against it, but is kept at a distance from it by means of the spacing pillars (25).

2. Distance sensor according to the preceding claim, **characterized in that** the external diameter of the pot (20) corresponds to the external diameter of the front, larger flange (19) and to the internal diameter of a surrounding housing (12).

3. Distance sensor according to one of the preceding claims, **characterized in that** the annular space between the winding support (17) and the pot wall (21) is filled with the coil (16).

4. Distance sensor according to one of the preceding claims, **characterized in that** the pot (20) is equipped on its base (24) with a core (31) which engages coaxially in the winding support (17).

5. Distance sensor according to the preceding claim, **characterized in that** the base (24) of the pot (20) rests against the pillars (25), and its end wall (22) rests against an annular area of the front flange (19).

6. Distance sensor according to Claim 2, further comprising a hollow-cylindrical surrounding housing (12) in which the pot (20) is arranged, wherein a printed circuit board (13) in the form of a circular disc is arranged between the pot base (24) and the base of the surrounding housing (12).

7. Distance sensor according to the preceding claim, **characterized in that** the coil (16) is connected to the printed circuit board (13) through longitudinal channels (26) in the pillars (25) and through holes (27) in the pot base (24).

8. Distance sensor according to Claim 2, **characterized in that** the coil former (15) together with the pot (20) closes, on the measurement side, flush with the end (23) of the distance sensor surrounding housing (12).

## Revendications

1. Capteur de distance (11) inductif avec un corps de bobine (15) dont le support de bobinage (17) tubulaire est équipé d'un noyau (31) ferromagnétique et entre des brides (18, 19), sur ses extrémités frontales est équipé d'une bobine (16), deux brides (18, 19) en forme d'anneau circulaire de différents diamètres extérieurs étant prévues et le corps de bobine (15) équipé étant placé dans un pot (20) électromagnétique, dont le diamètre intérieur correspond au diamètre extérieur de la plus petite bride (18) arrière, **caractérisé en ce que** derrière la bride (18) arrière sont prévus des piliers d'écartement et **en ce que** le fond inférieur (24) du pot (20) n'est pas directement adjacent à la bride arrière (18), derrière celle-ci, mais est maintenu à distance de cette dernière, au moyen des piliers d'écartement (25).

2. Capteur de distance selon la revendication précédente, **caractérisé en ce que** le diamètre extérieur du pot (20) correspond au diamètre extérieur de la bride (19) avant la plus grande et au diamètre intérieur d'un boîtier (12) enveloppant.

3. Capteur de distance selon l'une quelconque des revendications précédentes, **caractérisé en ce que** l'espace annulaire entre le support de bobinage (17) et la paroi (21) du pot est rempli par la bobine (16).

4. Capteur de distance selon l'une quelconque des revendications précédentes, **caractérisé en ce que**, sur son fond inférieur (24), le pot (20) est muni d'un noyau (31) s'engageant de manière coaxiale dans le support de bobinage (17).

5. Capteur de distance selon la revendication précédente, **caractérisé en ce que** par son fond inférieur (24), le pot (20) est adjacent aux piliers (25) et par son bord frontal (22), est adjacent à une région annulaire de la bride (19) avant.

6. Capteur de distance selon la revendication 2, comprenant par ailleurs un boîtier (12) enveloppant dans lequel est placé le pot (20), une carte de circuits imprimés à conducteurs (13) de forme discoïdale étant placée entre le fond inférieur (24) du pot et le fond inférieur du boîtier (12) enveloppant.

7. Capteur de distance selon la revendication précédente, **caractérisé en ce que** la bobine (16) est raccordée sur la carte de circuits imprimés (13) par des canaux longitudinaux (26) dans les piliers (25) et à travers des trous (27) dans le fond inférieur (24) du pot.

8. Capteur de distance selon la revendication 2, **caractérisé en ce que** le corps de bobine (15) avec le pot (20) se termine côté mesure à fleur du front (23) du boîtier (12) enveloppant du capteur de distance.
